# EUROPEAN PATENT SPECIFICATION

(11) **EP 2 533 102 B1**
(45) Date of publication and mention of the grant of the patent: **25.03.2015**
(21) Application number: 12275047.4
(22) Date of filing: 13.04.2012
(51) Int. Cl.: G03F 7/16, B05C 5/00, B05C 11/08

(54) **Method for spin-coating and method for manufacturing substrate having structure**
Verfahren zur Schleuderbeschichtung und Verfahren zur Herstellung eines Substrats mit Struktur
Procédé de revêtement par centrifugation et procédé de fabrication d'un substrat ayant la structure

(30) Priority: 07.06.2011 KR 20110054559
(43) Date of publication of application: 12.12.2012
(73) Proprietor: Samsung Electro-Mechanics Co., Ltd, Suwon, Gyunggi-Do (KR)
(72) Inventor: Lee, Seung Seoup, Gyeonggi-do 446-739 (KR); Shin, Dong Chul, Gyeonggi-do 443-822 (KR)
(74) Representative: Potter Clarkson LLP

(56) References cited:
- US-A- 5 849 435
- US-A- 6 106 618
- US-A1- 2008 204 675

## Description

### BACKGROUND OF THE INVENTION

### 1. Technical Field

The present invention relates to a method for spin-coating which simultaneously perform spin-coating and pre-baking processes, and a method for manufacturing a substrate having a structure.

### 2. Description of the Related Art

In recent years, micro-electronic devices are being increasingly applied to diverse fields, in particular, to smart phones. Such a micro-electronic device constitutes a sensor or an actuator having a micro size based on a Si substrate using a semiconductor processing technique called a Micro Electro Mechanical System (MEMS), and performs diverse function. For example, many types of sensors, which realize functions of an original sensor using the MEMS technology, while improving performance and efficiency of the sensor, such as an inertial sensor (a gyro sensor or an acceleration sensor), a geomagnetic sensor, and a microphone applied to smart phones, are being applied to actual products. Also, the MEMS technology is being increasingly applied to various functional parts of a camera module mounted in a mobile phone or a smart phone, such as a shutter and an A/F.

However, in the structure such as an MEMS sensor or actuator, a plurality of structures having a high sidewall with a high aspect ratio exist. It is a difficult process to achieve a high aspect ratio during a micro manufacturing process. In this case, it is normal that patterning is performed using a photoresist (PR) having very high viscosity, but this method still has its limitations. For example, in a structure of a high aspect ratio (a ratio of width to height) of 5:1 or more, patterning using a PR with only high viscosity has limitations.

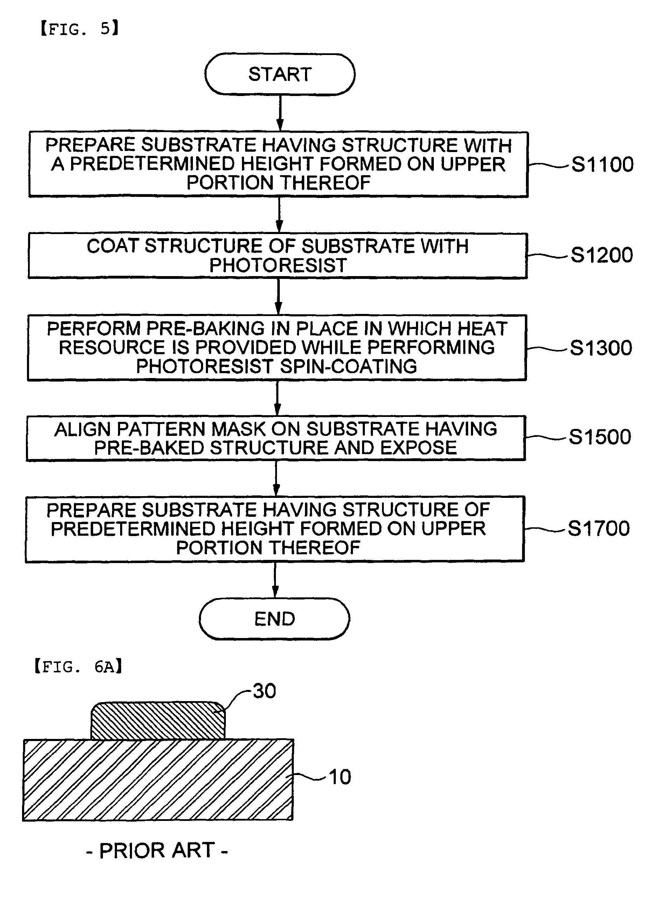

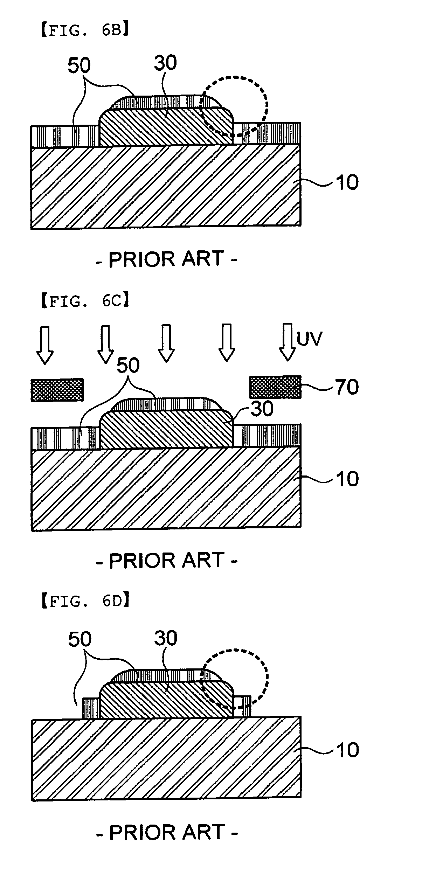

A related art method for manufacturing a substrate having the above structure will be explained with reference to FIG. 6. FIG. 6 is a schematic view illustrating a related art method for manufacturing a substrate having the above structure. A photoresist pattern is formed by applying a photolithography process of a semiconductor process. The photolithography process is a process of realizing a minute pattern of a thin film using photo developing and etching technologies, and mainly uses a photoresist as a mask material for thin film etching. The photoresist pattern is formed by forming a photoresist film and exposing and developing the photoresist film using an exposing mask, according to an order of (a) to (d) of FIG. 6. After the patterning process using the photoresist has proceeded, a thin film process or a plating process may further proceed according to what element is manufactured.

In FIG. 6, (a) illustrates a process of preparing a substrate, (b) illustrates a process of performing spin-coating of a photoresist on the substrate, (c) illustrates a process of aligning a mask and exposing the mask to an ultraviolet light source, and (d) illustrates a process of developing the photoresist.

If a subsequent process is performed with a solvent being contained in a photoresist layer, tolerance of the photoresist layer may worsen in a subsequent developing or etching process and thickness of the photoresist continuously varies and as a result, constant process conditions cannot be maintained. Accordingly, in order to remove the solvent remaining on the photoresist layer after the spin-coating process of (b), a pre-baking process is performed before the exposing process of (c). The developing process of (d) includes a baking process.

In the related art photoresist pattern forming method, when the photoresist of the structure of the high aspect ratio is coated, as shown in (b) of FIG. 6, step coverage may worsen and thus a photoresist disconnection phenomenon occurs on a sidewall or an edge portion. Therefore, process reliability in the MEMS process frequently deteriorates, it is difficult to process a pattern having a large thickness with a high aspect ratio, or much time and money are required in developing a special photoresist having high viscosity.

US-A-5849435 discloses a method for forming a layer of resist on a non planar substrate by spin coating.

### SUMMARY OF THE INVENTION

In order to solve the problems described above, much time and money have been invested in developing a photoresist having high viscosity and also capable of going through a spin coating process, and also, even if such a photoresist is developed, there is no guarantee that the photoresist is applied to all cases. Therefore, a fundamental solution to the above problems has been demanded.

An object of the present invention is to provide a method for spin-coating as claimed in claim 1, which can simultaneously perform a spin-coating process and a pre-baking process, and a method for manufacturing a substrate having a structure as claimed in claim 6.

More specifically, an object of the present invention is to provide a method, which heats a substrate directly or indirectly and controls the substrate to be at a constant temperature, and performs a spin coating process of a photoresist and simultaneously performs a pre-baking process, which is a post-process of the photoresist coating in a related art.

A spin-coating apparatus includes: a support supporting a substrate having a structure, a motor rotating the support so that the structure is spin-coated, and a heat source heating a coating material which is subjected to the spin-coating to perform pre-baking.

The spin-coating apparatus may further include a chamber in which the support, the motor, and the heat source are disposed, the heat source may be a heater disposed above the support, and the heater may heat the coating material to perform pre-baking. The spin-coating apparatus may further include an air circulator disposed at one side in the chamber, and heat generated by the heater may be convected by the air circulator and the coating material may be pre-baked by convective heat.

The support may be integrally formed with the heat source, and the heat source may heat the substrate and pre-bake the coating material of the substrate.

The heat source may be a heater disposed under the support, and the heater may indirectly heat the substrate supported on the support through the support and may pre-bake the coating material of the substrate.

The spin-coating apparatus may further include a trench formed along an outer circumference of the support which collects coating liquid scattered by the spin-coating.

The chamber may have an upper side, a lower side, or a lateral side formed to be opened and closed or separated.

According to an embodiment of the present invention, there is provided a method for spin-coating a substrate having a structure, the method including: preparing the substrate having the structure of a predetermined height formed on an upper portion thereof, coating the structure of the substrate with photoresist, and performing spin-coating of the photoresist in a place in which a heat source is provided, while performing pre-baking of the photoresist in the place.

The structure may have the predetermined height such that an upper surface of the structure is coated in part or in whole and at least part of a lateral surface of the structure is coated, and the height may be thicker than a thickness of an upper coating film to be formed with the spin-coating.

The structure may be a high structure having an aspect ratio of 5:1 or more.

The place in which the heat resource is provided may be a chamber, and pre-baking may be performed by a heater disposed above the substrate in the chamber.

The pre-baking may be performed by heat transmitted from a support that supports and rotates the substrate subjected to the spin-coating.

According to the present invention, there is provided a method for manufacturing a substrate having a structure applying a photolithography process, the method according to claim 6 including: preparing the substrate having the structure and performing spin-coating of photoresist while performing pre-baking of photoresist according to the above-described spin-coating method, aligning a pattern mask on the substrate having the pre-baked structure and exposing the pattern mask, and developing a photoresist after the exposure.

### BRIEF DESCRIPTION OF THE DRAWINGS

FIG. 1 is a schematic view of a spin-coating apparatus according to an exemplary embodiment;
FIG. 2 is a schematic view of a spin-coating apparatus according to another exemplary embodiment;
FIG. 3 is a schematic view illustrating a method for manufacturing a substrate having a structure according to still another exemplary embodiment;
FIG. 4 is a flowchart illustrating a method for spin-coating a substrate having a structure according to still another exemplary embodiment;
FIG. 5 is a flowchart illustrating a method for manufacturing a substrate having a structure according to still another exemplary embodiment; and
FIG. 6 is a schematic view illustrating a related art method for manufacturing a substrate having a structure.

### DESCRIPTION OF THE PREFERRED EMBODIMENTS

Unless one element is mentioned as being 'directly connected' to another element or 'directly coupled' to another element, simply mentioning 'connected' or 'coupled' may indicate 'directly connected' or 'directly coupled' and furthermore may indicate that still another element is inserted therebetween and connected or coupled.

Even if the singular expression is used in the present specification, the singular expression is intended to include the plural expression unless the plural expression violates the concept of the present invention, is contradictory to the interpretation of the present invention, or the context clearly indicates otherwise. It will be further understood that the terms 'includes', 'has', 'comprises', and/or 'consists of' do not preclude the presence or addition of one or more other features or elements or combination thereof.

Hereinafter, a spin-coating apparatus according to exemplary embodiments will be explained in detail with reference to the accompanying drawings.

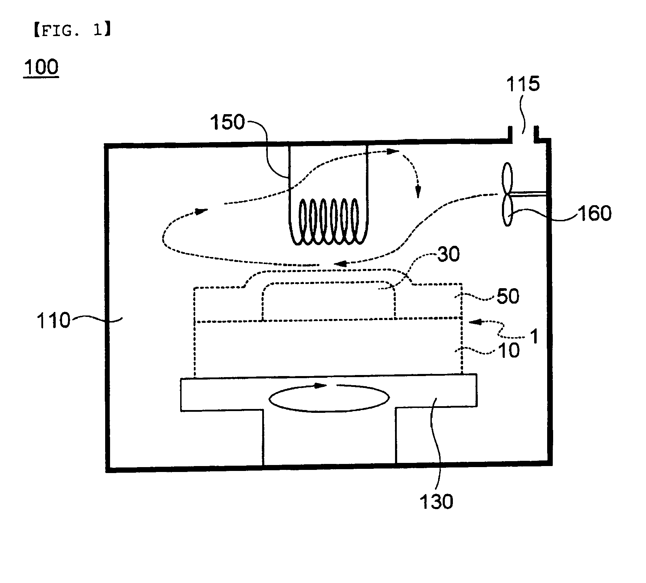

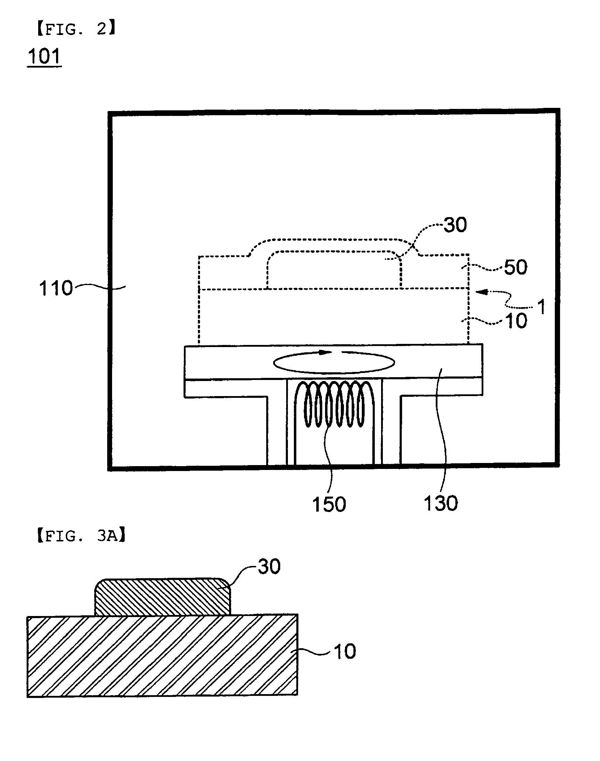

FIG. 1 is a schematic view of a spin-coating apparatus according to an exemplary embodiment, and FIG. 2 is a schematic view of a spin-coating apparatus according to another exemplary embodiment.

Referring to FIGS. 1 and/or 2, a spin-coating apparatus 100 and/or 101 according to exemplary embodiments includes a support 130, a motor (not shown), and a heat source. An embodiment of the present invention may exclude a chamber 110 shown in FIGS. 1 and/or 2. In one example, the spin-coating apparatus 100 and/or 101 may further include the chamber 110 as shown in FIGS. 1 and/or 2. In general, the spin-coating apparatus rotates a substrate 10 such that a photoresist 50 is coated over an upper portion of the substrate to have a uniform thickness. The thickness of the photoresist 50 may be controlled by controlling an amount of a photoresist sprayed over an upper portion of a structure 30 of the substrate by a spraying apparatus (not shown), and a rotation speed of the substrate.

Referring to FIGS. 1 and/or 2, the support 130 of the spin-coating apparatus 100, 101 of the present invention supports a substrate 1 having a structure. In one example, the support 130 may be disposed in the chamber 110 as shown in FIGS. 1 and/or 2.

Although not shown, the motor rotates the support 130 so that the structure 30 could be spin-coated.

The heat source heats a coating material, which is subjected to the spin-coating to perform pre-baking. An example of the heat source may be a heater 150 shown in FIGS. 1 and 2. In one example, the coating material may be the structure 30 on the substrate 10 over which the photoresist 50 is coated, or may be the photoresist 50 itself. In one example, the heat source, for example, the heater 150 may be disposed in the chamber 110 as shown in FIGS. 1 and/or 2.

Using the spin-coating apparatus according to an exemplary embodiment, the spin-coating and the pre-baking are simultaneously performed so that a photoresist disconnection in a high pattern structure can be prevented and also a pile up or a bump generated on an edge portion after the spin-coating process in the related-art can be prevented during the spin-coating process. The pile up is not generated on the edge portion so that an upper coating surface can be coated more evenly and smoothly.

According to an exemplary embodiment, as shown in FIGS. 1 and/or 2, the spin-coating apparatus 100, 101 may further include the chamber 110 and the substrate 1 having the structure 30 to be spin-coated is placed in the chamber 110.

Another exemplary embodiment will be explained below.

Referring to FIG. 1, according to another exemplary embodiment, the spin-coating apparatus 100 may further include the chamber 110 in which the support 130, the motor (not shown), and the heat source (for example, the heater 150) are disposed. The heat source of the spin-coating apparatus 100 is the heater 150 disposed above the support 130. The heater 150 heats the coating material to perform the pre-baking. An amount of radiant energy to be transmitted to the coating material from the heater 150 may be adjusted by changing a height of the support 130 or changing a gap between the coating material and the heater 150 other than directly controlling the heater 150.

According to another exemplary embodiment, the spin-coating apparatus 100 may further include an air circulator 160 disposed at one side in the chamber 110 as shown in FIG. 1. The air circulator convects heat generated by the heater 150. The coating material is pre-baked by the convective heat.

In one example, as shown in FIG. 1, the chamber 110 may further include a ventilating opening 115. External air and internal air in the chamber 110 are exchanged with each other through the ventilating opening 115.

Still another exemplary embodiment will be explained. According to still another exemplary embodiment, the support 130 is integrally formed with the heat source. In other words, the support 130 serves as the heat source. For example, the support 130 includes a heat emitting body to serve as the heat source. According to the present exemplary embodiment, the heat source heats the substrate 10 and pre-bakes the coating material of the substrate.

Still another exemplary embodiment will be explained with reference to FIG. 2.

Referring to FIG. 2, according to still another exemplary embodiment, the heat source is the heater 150 disposed under the support 130. The heater 150 heats the substrate 10 supported on the support 130 through the support 130. As a result, the heater 150 pre-bakes the coating material of the substrate through the support 130. The radiant energy transmitted to the coating material may be adjusted by directly controlling the heater 150 or changing a gap between the support 130 and the heater 150. Although shown in FIG. 2, the chamber 110 may be excluded in one exemplary embodiment. In one example, although not shown, instead of the chamber 110, a wall may be disposed along an outer circumference of the support 130 to block a coating liquid that scatters during the spin-coating.

Still another exemplary embodiment will be explained. According to still another exemplary embodiment, a trench (not shown) may be further formed along the outer circumference of the support 130 to collect the coating liquid scattered during the spin-coating. In one example, the trench (not shown) may include a wall which is formed along the outer circumference of the support 130 to block the coating liquid scattered during the spin-coating, and a guide recess (not shown) which guides and collects the coating liquid flowing down along the wall. Also, as shown in FIGS. 1 and/or 2, if the chamber 110 is further included, the trench (not shown) may be formed on an inner surface of the chamber 110 and the inner surface of the chamber 110 serves as the wall of the trench.

In the present exemplary embodiment, the coating liquid scattered toward the outer circumference of the support 130 during the spin-coating, for example, the photoresist flows down along the wall of the trench (not shown) or the inner surface of the chamber 110 and is collected in the trench (not shown) or the guide recess (not shown) of the trench. Although not shown, forming the trench (not shown) along the outer circumference of the support 130 or on the inner surface of the chamber 110 can be easily achieved by an ordinary skilled person in the related art without additional drawings or description.

Still another exemplary will be explained. According to still another exemplary embodiment, although not shown, the chamber 110 illustrated in FIGS. 1 and/or 2 may have an upper side, a lower side or a lateral side formed to be opened and closed or separated. Accordingly, the substrate 1 having the structure 30 can be easily placed in the, chamber 110. At this time, the substrate 1 having the structure 30 coated with the photoresist 50 may be placed in the chamber 110 for the spin-coating and the pre-baking, or the substrate 1 having the structure 30 and already placed in the chamber 110 may be coated with the photoresist 50. Forming the upper side, the lower side or the lateral side of the chamber 110 to be opened and closed or separated can be easily achieved by an ordinary skilled person in the related art without an additional detailed description.

Next, a method for spin-coating a substrate having a structure according to still another exemplary embodiment will be explained with reference to the accompanying drawings. Reference numerals assigned for easy understanding of the present invention are directly written on the drawings or are the same as in FIGS. 1 and/or 2 for describing the spin-coating apparatus 100, 101.

A photoresist in a photolithography process is in a liquid state and has viscosity, and is generally uniformly coated over a substrate by spin-coating. In a rotating state for coating, a fluid film of a uniform thickness, which is determined by a rotation speed and viscosity of a fluid, is coated over a structure, uniformly maintaining the thickness, even if the structure has a high aspect ratio. However, once the spin coating is completed, a disconnection of a doping film occurs on an edge portion of the structure having the high aspect ratio due to the viscosity of the fluid. In the present invention, by performing the pre-baking process to evaporate a binder or a volatile material at the same time as performing the spin-coating process, disconnection of the photoresist can be prevented and also productivity of the photolithography process can be improved.

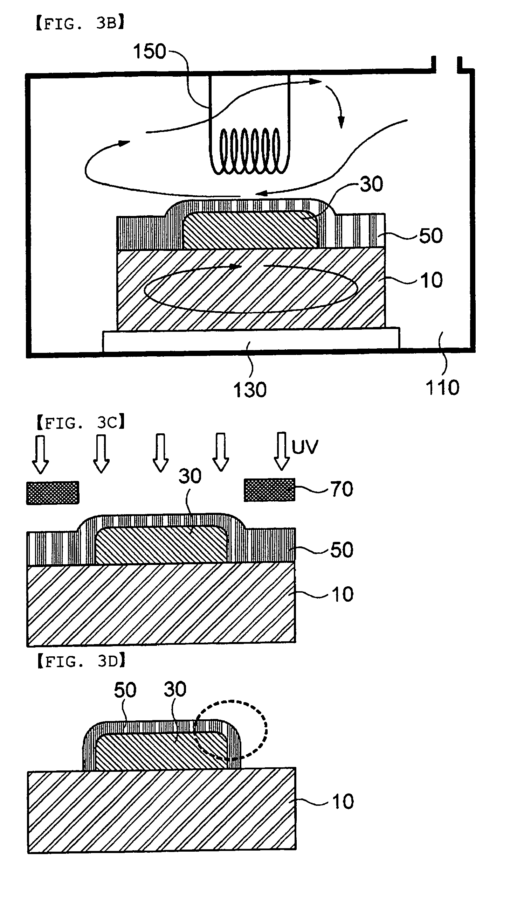

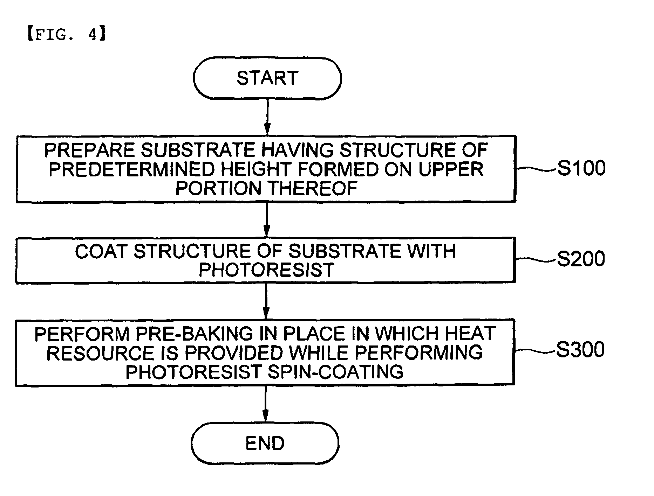

FIG. 4 is a flowchart illustrating a method for spin-coating a substrate having a structure according to still another exemplary embodiment. FIG. 3 is a schematic view illustrating a method for manufacturing a substrate having a structure according to still another exemplary embodiment, and (a) and (b) of FIG. 3 schematically illustrate a method for spin-coating a substrate having a structure.

Referring to FIG. 4 and (a) and (b) of FIG. 3, a method for spin-coating a substrate having a structure according to an exemplary embodiment includes preparing a substrate 1 having a structure shown in (a) of FIG. 3 (S100), coating a photoresist (S200), and performing spin-coating while performing pre-baking as shown in (b) of FIG. 3 (S300).

Referring to (a) of FIG. 3 and FIG. 4, the substrate 10 having the structure 30 of a predetermined height formed on an upper portion thereof is prepared (S100). In other words, the substrate 1 having the structure is prepared. The structure 30 has a predetermined height, for example, an element structure is formed on the upper portion of the substrate 10 prepared.

According to another exemplary embodiment, the structure 30 has a predetermined height so that its upper surface is coated in whole or in part and at least part of a lateral surface is coated. Also, the height of the structure 30 is thicker than a thickness of an upper coating film to be formed with the spin-coating. If the height of the side of the structure 30 to be coated is thicker than the thickness to be coated, a photoresist disconnection occurs. Therefore, the present invention is more beneficial in that case. In one example, the height of the side of the structure 30 is two times thicker than the thickness of the upper film to be coated.

According to another exemplary embodiment, the structure 30 has a high aspect ratio of 5:1 or more.

The operation of coating the photoresist (S200) will be explained with reference to FIG. 4. Referring to FIG. 4, the photoresist 50 is coated over the structure 30 of the substrate 1 (S200). In one example, the substrate 1 having the structure coated with the photoresist 50 is provided in a place where a heat source is disposed. In one example, the place where the heat source is disposed may be the chamber 110 shown in FIGS. 1 and/or 2. In one example, the substrate 1 having the structure is placed in the place where the heat source is disposed, for example, in the chamber 110 shown in FIGS. 1 and/or 2, and the photoresist 50 is coated over the structure 30 of the substrate 1.

Next, the operation of performing the spin-coating while performing pre-baking (S300) will be explained with reference to (b) of FIG. 3 and FIG. 4. Referring to (b) of FIG. 3 and FIG. 4, the photoresist spin-coating is performed with respect to the structure 30 of the substrate 1 coated with the photoresist 50 in a predetermined place, for example, in the chamber 110 shown in FIGS. 1 and/or 2. The pre-baking is performed with respect to the coating material 30 of the substrate 1 in the place where the heat source is provided, for example, in the chamber 110 shown in FIG. 1 and/or 2, while performing the spin-coating (S300). Although (b) of FIG. 3 illustrates the chamber 110, this is merely an example. Although not shown, the spin-coating and the pre-baking may be simultaneously performed in a place which satisfies a condition that the spin-coating and the pre-baking are simultaneously performed without a chamber.

In the related-art, separate pre-baking is performed in order to remove a solvent remaining in a coating material after spin-coating. However, in the present invention, the spin-coating and the pre-baking are simultaneously performed so that a processing time can be shortened, step coverage of the high structure 30 formed on the substrate 10 can be improved, and a photoresist disconnection can be prevented from occurring on an edge portion or a side wall.

In performing the pre-baking, it is important to appropriately adjust temperature and time of pre-baking in order to remove only the solvent without pyrolyzing other components of the photoresist. In one example, the pre-baking may be performed during the spin-coating time. In one example, the spin-coating may be performed from 30 seconds to 1 minute.

Although not shown in (b) of FIG. 3, the pre-baking may be performed in the chamber 111 of the spin-coating apparatus 101 of FIG. 2 while the photoresist spin-coating is performed.

According to the method for spin-coating the substrate having the structure according to the exemplary embodiment, by performing the spin-coating and the pre-baking simultaneously, the photoresist disconnection of the high pattern structure can be solved. Furthermore, the pile up or the bump generated on the edge portion after the spin-coating in the related-art can be prevented.

Referring to (b) of FIG. 3 and/or FIG. 1, according to still another exemplary embodiment, the place where the heat source is provided is the chamber 110 and the pre-baking is performed by the heater 150 disposed above the substrate 1 in the chamber 110.

Also, according to still another exemplary embodiment, the air circulator 160 is provided in the chamber 110 as shown in FIG. 1 and the coating material which is subjected to the spin-coating is pre-baked as the heat of the heater 150 is convected by the air circulator 160.

Although not shown in (b) of FIG. 3, referring to FIG. 2, according to still another exemplary embodiment, the pre-baking may be performed by heat transmitted through the support 130, which supports and rotates the substrate 1 where the spin-coating is being performed. As shown in FIG. 2, the heat may be transmitted to the substrate 10 and the coating material 30 of the substrate 10 from the heater 150 disposed under the support 130 through the support 130. Although not shown in FIG. 2, the support 130 may include a heat emitting body to serve as the heat source.

Next, a method for manufacturing a substrate having a structure applying a photolithography process according to still another exemplary embodiment will be explained.

FIG. 3 is a schematic view illustrating a method for manufacturing a substrate having a structure according to still another exemplary embodiment, and FIG. 5 is a flowchart illustrating a method for manufacturing a substrate having a structure according to still another exemplary embodiment.

Referring to FIGS. 3 and 5, the method for manufacturing the substrate having the structure applying the photolithography process according to still another exemplary embodiment includes preparing a substrate 1 having a structure (S1100), coating a photoresist (S1200), performing spin-coating of photoresist while performing pre-baking of photoresist (S1300), exposing (S1500), and developing (S1700).

The operations of preparing the substrate 1 having the structure shown in (a) of FIG. 3 (S1100), coating the photoresist (S1200), and performing spin-coating while performing the pre-baking of the photoresist shown in (b) of FIG. 3 (S1300) are the same as the operations of the method for spin-coating the substrate having the structure described above (S100, S200, and S300 of FIG. 4). Accordingly, since the spin-coating is performed under the temperature of the pre-baking, a photoresist disconnection can be prevented from occurring on an edge portion or a sidewall portion of the structure 30 having a high aspect ratio.

Referring to (c) of FIG. 3 and FIG. 5, a pattern mask 70 is aligned on the substrate 1 having the structure, which has been pre-baked, and exposed in the exposing operation (S1500). An aligning process is performed in parallel to precisely control a position to be exposed. A light source for the exposing process generally uses light with a short-wavelength. In one example, the pattern mask 70 is exposed to a UV light source after the aligning process.

Illustration (c) of FIG. 3 illustrates an example of the exposing process for the negative photo resist 50, but the present invention should not be limited thereto.

Next, referring to (d) of FIG. 3 and FIG. 5, the photoresist 50 is developed during the developing operation (S1700) after the exposing operation. In the developing operation of (d) of FIG. 3, a photo resist layer in which a bond is relatively weakened during the exposing process is melted using a developing agent. Illustration (d) of FIG. 3 illustrates that a non-exposed portion by the negative photoresist is melted. However, the present invention should not be limited to this.

The exposing process and the developing process of the photolithography are well known in the related art and thus a detailed description thereof is omitted.

According to the invention, the spin-coating apparatus, which performs the pre-baking process, which is a post process of the photoresist coating process in the related-art, at the same time as performing the spin-coating of the photoresist, the spin-coating method simultaneously performing the pre-baking process and the spin-coating process, and the method for manufacturing the substrate having the structure are realized.

Specifically, according to the present invention the following effects are obtained:
First, a photoresist disconnection of a high pattern structure can be prevented and accordingly photoresist coating can be performed without using a special photoresist.
Second, a photoresist of high chemical resistance is utilized so that reliability of an additional process can be improved and a window of product development can be expanded.
Third, the spin-coating and the pre-baking are simultaneously performed so that a processing time of a photoresist forming process or a photolithography process can be shortened.
Fourth, a photoresist pattern with a high aspect ratio can be easily realized.
Fifth, the photolithography process of the semiconductor process is easily applied to elements of various patterns, so that mass production, high productivity, and a high degree of pattern precision can be guaranteed and thus a manufacturing cost saving effect can be expected by reducing a process error and a dispersion error.

Although the preferred embodiments of the present invention have been disclosed for illustrative purposes, those skilled in the art will appreciate that various modifications, additions, and substitutions are possible, without departing from the scope of the appended claims.

## Claims

1. A method for spin-coating a substrate (10) having a structure (30), the method comprising:
preparing the substrate (10) having the structure (30) of a predetermined height formed on an upper portion thereof;
coating the structure (30) of the substrate (10) with photoresist (50); and
performing spin-coating of the photoresist (50) in a place in which a heat source (150) is provided, while simultaneously performing pre-baking of the photoresist (50) in the place.

2. The method according to Claim 1, wherein the structure (30) has the predetermined height so that an upper surface of the structure (30) is coated in part or in whole and at least a part of a lateral surface of the structure (30) is coated,
wherein the height is thicker than a thickness of an upper coating film to be formed with the spin-coating.

3. The method according to Claim 1, wherein the structure (30) is a high structure having an aspect ratio of 5:1 or more.

4. The method according to Claim 1, wherein the place in which the heat resource (150) is provided is a chamber (110),
wherein the pre-baking is performed by a heater (150) disposed above the substrate (10) in the chamber (110).

5. The method according to Claim 1, wherein the pre-baking is performed by heat transmitted from a support (130) that supports and rotates the substrate (10) subjected to the spin-coating.

6. A method for manufacturing a substrate having a structure applying a photolithography process, the method comprising:
preparing the substrate (10) having the structure (30) of a predetermined height formed on an upper portion and performing spin-coating of photoresist (50) while simultaneously performing pre-baking of photoresist (50) according to the spin-coating method according to Claim 1;
aligning a pattern mask (70) on the substrate (10) having the pre-baked structure (50) and exposing the pattern mask(70); and
developing a photoresist (50) after the exposure.

## Patentansprüche

1. Ein Verfahren zum Schleuderbeschichten eines Substrats (10) mit einer Struktur (30), wobei das Verfahren aufweist:
Vorbereiten des Substrats (10) mit der Struktur (30) einer vorbestimmten Höhe, die an einem oberen Abschnitt davon ausgebildet ist,
Beschichten der Struktur (30) des Substrats (10) mit einem Photoresist (50), und
Ausführen eines Schleuderbeschichtens des Photoresists (50) an einem Ort, an dem eine Wärmequelle (150) vorgesehen ist, während gleichzeitig ein Vorbacken des Photoresists (50) an dem Ort ausgeführt wird.

2. Das Verfahren gemäß Anspruch 1, wobei die Struktur (30) eine vorbestimmte Höhe besitzt, derart, dass eine obere Oberfläche der Struktur (30) teilweise oder ganz beschichtet wird und zumindest ein Teil einer lateralen Oberfläche der Struktur (30) beschichtet wird,
wobei die Höhe dicker ist als eine Dicke eines oberen Beschichtungsfilms, der mit dem Schleuderbeschichten auszubilden ist.

3. Das Verfahren gemäß Anspruch 1, wobei die Struktur (30) eine hohe Struktur mit einem Aspektverhältnis von 5:1 oder höher ist.

4. Das Verfahren gemäß Anspruch 1, wobei der Ort, an dem die Wärmequelle (150) vorgesehen ist, eine Kammer (110) ist,
wobei das Vorbacken durch eine Heizeinrichtung (150) ausgeführt wird, die über dem Substrat (10) in der Kammer (110) angeordnet ist.

5. Das Verfahren gemäß Anspruch 1, wobei das Vorbacken durch Wärme ausgeführt wird, die von einem Träger (130) übertragen wird, der das Substrat (10), das dem Schleuderbeschichten ausgesetzt wird, trägt und dreht.

6. Ein Verfahren zum Herstellen eines Substrats mit einer Struktur unter Anwenden eines Photolithographieprozesses, wobei das Verfahren aufweist:
Vorbereiten des Substrats (10) mit der Struktur (30) einer vorbestimmten Höhe, die an einem oberen Abschnitt davon ausgebildet ist, und Ausführen eines Schleuderbeschichtens von Photoresist (50), während gleichzeitig ein Vorbacken von Photoresist (50) gemäß dem Schleuderbeschichtungsverfahren gemäß Anspruch 1 ausgeführt wird,
Ausrichten einer Mustermaske (70) auf dem Substrat (10) mit der vorgebackenen Struktur (50) und Belichten der Mustermaske (70), und
Entwickeln eines Photoresists (50) nach der Belichtung.

## Revendications

1. Procédé pour revêtir par centrifugation un substrat (10) comportant une structure (30), le procédé comprenant :
la préparation du substrat (10) comportant la structure (30) d'une hauteur prédéterminée formée sur une portion supérieure de celui-ci ;
le revêtement de la structure (30) du substrat (10) d'une résine photosensible (50) ; et
la réalisation d'un revêtement par centrifugation de la résine photosensible (50) dans un lieu où est prévue une source de chaleur (150), tout en réalisant simultanément une précuisson de la résine photosensible (50) dans le lieu.

2. Procédé selon la revendication 1, dans lequel la structure (30) a la hauteur prédéterminée de sorte qu'une surface supérieure de la structure (30) soit revêtue en tout ou partie et qu'au moins une partie d'une surface latérale de la structure (30) soit revêtue,
dans lequel la hauteur est plus épaisse qu'une épaisseur d'un film de revêtement supérieur à former avec le revêtement par centrifugation.

3. Procédé selon la revendication 1, dans lequel la structure (30) est une structure élevée ayant un rapport d'aspect de 5 : 1 ou plus.

4. Procédé selon la revendication 1, dans lequel le lieu où est prévue la source de chaleur (150) est une chambre (110),
dans lequel la précuisson est réalisée par un élément chauffant (150) disposé au-dessus du substrat (10) dans la chambre (110).

5. Procédé selon la revendication 1, dans lequel la précuisson est réalisée par la chaleur transmise par un support (130) qui supporte et met en rotation le substrat (10) soumis au revêtement par centrifugation.

6. Procédé de fabrication d'un substrat comportant une structure appliquant un processus de photolithographie, le procédé comprenant :
la préparation du substrat (10) comportant la structure (30) d'une hauteur prédéterminée formée sur une portion supérieure et la réalisation d'un revêtement par centrifugation de résine photosensible (50) tout en réalisant simultanément une précuisson de la résine photosensible (50) selon le procédé de revêtement par centrifugation selon la revendication 1 ;
l'alignement d'un masque à motif (70) sur le substrat (10) comportant la structure précuite (50) et l'exposition du masque à motif (70) ; et
le développement d'une résine photosensible (50) après l'exposition.
